# EUROPÄISCHE PATENTSCHRIFT

(11) **EP 0 671 480 B1**
(45) Veröffentlichungstag und Bekanntmachung des Hinweises auf die Patenterteilung: **04.09.1996**
(21) Anmeldenummer: 94111923.2
(22) Anmeldetag: 30.07.1994
(51) Int. Cl.: C23C 14/08, C23C 14/34, C23C 14/00, C04B 35/00

(54) **Sputtertarget für die Kathodenzerstäubung zur Herstellung transparenter, leitfähiger Schichten**
Sputtering target used in cathode sputtering procedures for producing transparent electroconductive films
Cible de pulvérisation destinée à la pulvérisation cathodique pour la fabrication de couches électroconductrices transparentes

(30) Priorität: 09.03.1994 DE 4407774
(43) Veröffentlichungstag der Anmeldung: 13.09.1995
(73) Patentinhaber: LEYBOLD MATERIALS GmbH, D-63450 Hanau (DE)
(72) Erfinder: Schlott, Martin, Dr., D-63454 Hanau (DE); Kutzner, Martin, D-63543 Neuberg (DE); Weigert, Martin, Dr., D-63457 Hanau (DE); Konietzka, Uwe, D-63826 Geiselbach (DE); Gehman, Bruce, Dr., Morgan Hill, CA 95037 (US); Valstrom, Shawn, Morgan Hill, CA 95037 (US)

(56) Entgegenhaltungen:
- EP-A- 0 342 537
- DE-A- 4 037 733
- DE-C- 4 124 471
- PATENT ABSTRACTS OF JAPAN, unexamined applications, C Field, Band 16, Nr. 349, 28. Juli 1992 THE PATENT OFFICE JAPANESE GOVERNMENT Seite 100 C 967; & JP-A-04 104 936 (SUMITOMO METAL MINING CO., LTD.)

## Beschreibung

Die Erfindung betrifft ein Sputtertarget für die Kathodenzerstäubung zur Herstellung transparenter, elektrisch leitfähiger Schichten, hergestellt aus teilweise reduzierten Indiumoxid-Zinnoxid-Pulvergemischen oder teilweise reduzierten kogefällten Indiumoxid-Zinnoxid-Pulvern, und ein Verfahren zur Herstellung dieser Targets.

Oxidkeramische Targets aus Indiumoxid-Zinnoxid (ITO) werden zur Herstellung tranparenter, elektrisch leitfähiger, dünner Schichten durch Kathodenzerstäubung (Sputtern) eingesetzt. Anwendung finden solche Schichten vor allem in der Flachbildschirmtechnik. Die Indiumoxid-Zinnoxid-Dünnschichten können entweder durch Sputtern metallischer Targets in sauerstoffreaktiver Atmosphäre oder durch Sputtern oxidkeramischer Targets hergestellt werden.

Der Sputterprozeß mit oxidkeramischen Targets hat den Vorteil, daß die Regelung des Sputterprozesses bei einem nur geringen Sauerstofffluß in der Sputterkammer leichter möglich ist als bei den hohen Sauerstoffflüssen, wie sie beim Sputtern mit metallischen Targets notwendig sind.

Da es sich bei dem Indiumoxid/Zinnoxid um einen keramischen Werkstoff handelt, besteht ein wesentliches Problem bei der Targetfertigung darin, aus entsprechenden Pulvern Sputtertargets herzustellen, die rißfrei sind und genügend hohe mechanische Festigkeit aufweisen. Andernfalls besteht die Gefahr, daß die Targetplatten bei der Endbearbeitung reißen oder Bereiche an den Kanten abplatzen. Auch die thermische Belastung im Sputterbetrieb kann bei unzureichender Festigkeit und Temperaturwechselbeständigkeit des ITO-Materials zu Rissen im Target führen.

Eine weitere Forderung besteht darin, Targets hoher Dichte herzustellen, da Sputterergebnisse gezeigt haben, daß dichtere Targets Vorteile bezüglich der Sputterrate aufweisen und weniger stark zur Pickelbildung neigen. Letzteres ist vor allem wichtig, um einen störungsfreien Dauerbetrieb des Targets und der Sputteranlage zu gewährleisten.

In der De-OS 33 00 525 werden teilreduzierte Indiumoxid-Zinnoxid-Targets und ihre Herstellung beschrieben. Danach werden Indiumoxid-Zinnoxid-Pulvergemische unter reduzierten Bedingungen bei 850°C bis 1000°C heiß gepreßt, wobei die Oxide in einer Graphitheißpreßform oder durch Zugabe von Kohlenstoff oder kohlenstoffreisetzendem organischem Material heiß gepreßt werden. Während des Preßvorgangs werden die Oxide teilweise reduziert, so daß ein Target entsteht, das in seinem Sauerstoffgehalt gegenüber der stöchiometrischen Zusammensetzung abgereichert ist.

Mit diesem Verfahren können nur Targets mit Dichten < 91 % der theoretischen Dichte (TD), schlechtem elektrischen Widerstand (ρ = 0,1-0,6 Ωcm) und unzureichender mechanischer Stabilität hergestellt werden. Alle drei Faktoren wirken sich negativ auf den Einsatz als Sputtertarget aus.

In der DE 41 24 471 wird ein Verfahren zur Herstellung teilreduzierter ITO-Targets durch den Einsatz vorreduzierter ITO-Pulver und anschliessendem Heißpressen beschrieben. Dem vorbekannten Verfahren lag die Aufgabe zugrunde ITO-Targets herzustellen, deren Reduktionsgrad um weniger als 5 % schwankt und zwar dadurch, daß sehr homogen reduzierte Pulver durch Heißpressen zu Targetscheiben verdichtet werden.

Untersuchungen haben jedoch gezeigt, daß je nach Morphologie der teilreduzierten Pulver sehr schlechte Ergebnisse bezüglich der Targetdichte und der mechanischen Stabilität der Targetscheiben erzielt werden.

Aufgabe der vorliegenden Erfindung, ist es, die Nachteile der bekannten Targetwerkstoffe zu vermeiden und ein oxidkeramisches Target von hoher mechanischer Stabilität zu schaffen.

Gemäß der Erfindung wird diese Aufgabe dadurch gelöst, daß das Target aus einer oxidkeramischen Matrix gebildet ist in die metallische Phasenteile aus In und/oder Sn mit Größen unterhalb 50 µm in gleichmäßiger und fein verteilter Weise eingelagert sind und das eine Dichte von mehr als 96 % der theoretischen Dichte des volloxidischen Indiumoxid/Zinnoxid aufweist. Durch die erfindungsgemäße Lösung dieser Aufgabe wird erreicht, daß das Target problemlos mechanisch bearbeitet werden kann, daß mit dem Target hohe Sputterraten erzielt werden können und daß das Target wenig zur Pickelbildung neigt.

Überraschenderweise hat sich gezeigt, daß sich über heißisostatisches Pressen von geeigneten teilreduzierten Pulvergemischen aus Indiumoxid und Zinnoxid, oder entsprechenden teilreduzierten kogefällten Pulvern, hochdichte und durch ausgezeichnete Bruchzähigkeit gekennzeichnete Targetwerkstoffe herstellen lassen. Die erreichte Dichte liegt bei mindestens 96 % der theoretischen Dichte und die Bruchzähigkeit bei mindestens 1,5 MPa √m. Im Vergleich hierzu wurden beim Heißpressen unreduzierter ITO-Pulver lediglich 89 % der theoretischen Dichte und Bruchzähigkeiten von höchstens 1,1 MPa √m erreicht. Die nach der vorliegenden Erfindung hergestellten ITO-Targets zeichnen sich durch ein Gefüge aus, das neben der Matrix aus Indiumoxid und Zinnoxid fein verteilte metallische Phasen enthält. Die Größe der Metallphasen liegt im Bereich < 50 µm, wobei der überwiegende Teil kleiner 10 µm ist. Setzt man schwach reduzierte ITO-Pulver ein, so bestehen die metallischen Anteile vor allem aus Zinn. Bei stark reduzierten Pulvern liegt ein Gemisch bzw. eine Legierung aus Indium und Zinn vor.

Gefügeuntersuchungen an mit verschiedenen Verfahren hergestellten ITO Targets haben gezeigt, daß die Anwesenheit der oben erwähnten fein verteilten metallischen Phasen offensichtlich zu einer besseren Verdichtung und einer deutlichen Rekristallisation der Matrix aus Indiumoxid/Zinnoxid während des heißisostatischen Pressens führt. Dieses Ergebnis ist insofern überraschend, als unter Normalbedingungen keine Benetzung von Indiumoxid/Zinnoxid durch die Metalle Indium und Zinn beobachtet wird, und man daher keinen positiven Einfluß der flüssigen Phasen auf die Kompaktierung erwartet hätte. Neben der höheren Dichte ergibt sich durch die beobachtete Rekristallisierung außerdem ein wesentlich bruchzäheres Gefüge. Auch dies ist ein unerwartetes Ergebnis, da man in keramischen Materialien in der Regel bessere mechanische Eigenschaften bei Verringerung der Korngrößen erhält. Untersuchungen der Bruchflächen legen nahe, daß infolge der Rekristallisation vor allem eine bessere Haftung zwischen den einzelnen Oxidpartikeln erreicht wird. Außerdem wurde beobachtet, daß die metallischen Phasen eine rißstoppende Funktion übernehmen.

Im Laufe der Entwicklungsarbeiten hat sich gezeigt, daß bevorzugt dann gute Targets erhalten werden, wenn der Reduktionsgrad des Pulvers, definiert als der Sauerstoffverlust während der Reduktionsbehandlung im Verhältnis zum Sauerstoffgehalt des volloxydischen Pulvers, im Bereich von 0,02 bis 0,2 liegt. Ist der Reduktionsgrad niedriger, liegen zu wenig metallische Phasen vor, um den positiven Einfluß auf Verdichtung und Festigkeit noch zu erreichen. Ist der Reduktionsgrad höher, nehmen die Festigkeitswerte aufgrund zu großer und häufiger Metallausscheidungen wieder ab. Außerdem ist ein solches Target auch weniger gut geeignet, um gute ITO-Schichten herzustellen, da hierzu jetzt ein recht hoher Sauerstofffluß erforderlich ist. Um Pulver zu erhalten, die entsprechend der vorliegenden Erfindung ein vorteilhaftes Gefüge ergeben, ist der Reduktionsprozeß so zu führen, daß dabei fein verteilte und sehr kleine Metallausscheidungen (Größe < 50 µm, bevorzugt sogar < 10 µm) wachsen. Sind die Metallpartikel zu groß, haben sie auf die Festigkeit einen negativen Einfluß, da sie dann als mikroskopische Fehler im Gefüge wirken. Vorzugsweise wird das volloxydische ITO-Pulver einer Glühbehandlung in reduzierender Gasatmosphäre unterworfen, aber auch Glühung im Vakuum oder Zumischen von reduzierenden Feststoffen sind möglich. In letzterem Fall erfolgt die Reduktion jedoch stark lokal konzentriert, was in der Regel zu zahlreichen Metallpartikeln mit deutlich mehr als 50 µm Größe führt, so daß die aus diesem Pulver hergestellten Targets fleckig aussehen und schlechtere Bruchzähigkeiten aufweisen. Aus demselben Grund sollte die Reduktionsbehandlung auch bei Temperaturen unterhalb 1000°C, vorzugsweise unterhalb 800°C erfolgen. Die anschließende Kompaktierung des teilreduzierten Pulvers oder eines daraus hergestellten Grundkörpers erfolgt über heißisostatisches Pressen in einer ausgekleideten, vakuumdicht verschweißten Kompaktierungskanne bei einer Temperatur oberhalb des Schmelzpunktes der Indium-Zinn-Metallphasen.

Die folgenden Beispiele sollen die erfindungsmäßigen Targets und deren Herstellung näher erläutern:

### 1. Beispiel entsprechend der vorliegenden Erfindung:

Eine Mischung aus 900 g Indiumoxid und 100 g Zinnoxid wurde für 45 Min bei 720°C unter N2/H2-Atmosphäre (95/5) geglüht. Der Sauerstoffverlust der Probe betrug 15,20 g entsprechend einem Reduktionsgrad von 0,086. Rasteraufnahmen des Pulvers zeigten kugelförmige 1-10 µm große Metallphasen, deren Zinngehalt über 90 Gew % lag. 600 g der Mischung wurden kaltisostatisch zu einem Zylinder vorgepreßt und anschließend in einer ausgekleideten Stahlkanne bei 800°C und 200 MPa Druck in einer heißisostatischen Presse kompaktiert. Nach dem Entnehmen hatte der Indiumoxid-Zinnoxid-Körper einen Durchmesser von 81 mm und eine Dicke von 16,5 mm entsprechend 98,5 % der theoretischen Dichte. Der spezifische elektrische Targetwiderstand betrug 380 µΩcm, und die Bruchzähigkeit 1,6 MPa√m. Die mechanische Bearbeitung konnte problemlos durchgeführt werden. Während des Sputtertests wurde kein Arcing beobachtet und es wurden sehr gute Sputterraten erzielt. Gegenüber der Korngröße des eingesetzten Pulvers war ein deutliches Kornwachstum erkennbar, das von den fein verteilten Metallphasen ausging. Die Größe der Metallausscheidungen betrug wie im Pulver 1-10 µm, vereinzelt wurden bis zu 20 µm große Metallbereiche gefunden.

### 2. Vergleichsbeispiel:

Ein volloxydisches Indiumoxid/Zinnoxid-Pulvergemisch wurde wie unter 1.) zunächst kaltisostatisch vorgepreßt und anschließend in einer ausgekleideten Stahlkanne bei 750°C und 200 PMa Druck in einer heißisostatischen Presse kompaktiert. Der erhaltene Zylinder wies Risse auf und konnte nicht zu Targets weiterverarbeitet werden. Rasteraufnahmen des Materials zeigten ein nichtrekristallisiertes Gefüge mit der ursprünglichen Korngröße. Es lagen keine metallischen Ausscheidungen vor.

### 3. Beispiel entsprechend der vorliegenden Erfindung:

1000 g eines kogefällten Indiumoxid/Zinnoxid Pulvers (90/10 Gew %) wurde bei 420°C für 1 h unter Wasserstoffatmosphäre geglüht.

Der Sauerstoffverlust der Probe betrug 30,1 g entsprechend einem Reduktionsgrad von 0,17. Rasteraufnahmen des Pulvers zeigten 1-10 µm große kugelförmige Metallphasen, die zu etwa gleichen Teilen aus Indium und Zinn bestanden. 600 g des Pulvers wurden kaltisostatisch zu einem Zylinder vorgepreßt und anschließend in einer ausgekleideten Stahlkanne bei 750°C und 200 MPa Druck in einer heißisostatischen Presse kompaktiert,. Nach dem Entnehmen hatte der Indiumoxid-Zinnoxid-Körper einen Durchmesser von 80 mm und eine Dicke von 17,2 mm entsprechend 97 % der theoretischen Dichte. Der spezifische elektrische Widerstand betrug 320 µΩcm. und die Bruchzähigkeit 1,9 MPa √m. Die mechanische Bearbeitung konnte problemlos durchgeführt werden. Während des Sputtertests wurde kein Arcing beobachtet und es wurden sehr gute Sputterraten erzielt. Nach dem Test war das Target nahezu frei von Pickeln. Das Target wurde metallographisch untersucht. Gegenüber der Korngröße des eingesetzten Pulvers war ein deutliches Kornwachstum erkennbar, das von den fein verteilten Metallphasen ausging. Die Größe der Metallausscheidungen betrug 1-10 µm, wobei vereinzelt bis zu 30 µm große Metallbereiche gefunden wurden.

### 4. Vergleichsbeispiel:

Eine Mischung aus 900 g Indiumoxid und 100 g Zinnoxid wurde mit 0,1 g Kohlenstoffpulver vermischt und anschließend für 1,5 h bei 880°C unter Argon geglüht. Der Sauerstoffverlust der Probe betrug 7,9 g entsprechend einem Reduktionsgrad von 0,045 Rasteraufnahmen des Pulvers zeigten bis zu 200 µm große Metallpartikel, 800 g dieses Pulvers wurden wie unter 1.) kompaktiert. Der erhaltene Zylinder hatte einen Durchmesser von 85 mm und eine Höhe von 20,4 mm entsprechend 96,5 % der theoretischen Dichte. Der spezifische elektrische Targetwiderstand betrug 350 µΩcm und die Bruchzähigkeit 1,3 MPa√m. Die mechanische Bearbeitung mußte wegen der niedrigen Bruchzähigkeit schon sehr vorsichtig durchgeführt werden. Das erhaltene Target wies wegen der Größe der Metallaussscheidungen eine fleckige Oberfläche auf. Während des Sputtertests kam es zu gelegentlichen Arcing, so daß nicht die maximale Leistungsdichte und die maximale Sputterrate erreicht wurden. Das Target wurde metallographisch untersucht. Gegenüber der Korngröße des eingesetzten Pulvers war ein deutliches Kornwachstum erkennbar, das in der Umgebung der über 100 µm großen Metallauscheidungen wesentlich stärker ausgeprägt war als in den Bereichen ohne diese großen Metallphasen. Insgesamt war das Gefüge hierdurch sehr inhomogen.

### 5. Vergleichbeispiel:

300 g einer Mischung aus 900 g Indiumoxid und 100 g Zinnoxid wurden ohne Reduktionsbehandlung direkt in eine mit Bornitrid beschichtete Graphit-Heißpreßform von 80 mm Durchmesser gegeben und bei 870°C unter Argonatmosphäre mit einer max. Preßkraft von 20 MPa verdichtet. Die erhaltene Scheibe hatte eine Dicke von 9,4 mm entsprechend einer Dichte von 89 % der theoretischen Dichte. Der spezifische Targetwiderstand betrug 3600 µΩcm und die Bruchzähigkeit 1,1 MPa√m. Bei der mechanischen Endbearbeitung traten an den Kanten der Scheibe leichte Abplatzungen auf. Während des Sputtertests wurde wiederholt Arcing beobachtet. Die erreichten Sputterraten lagen ca. 15 % unter den Raten, die mit Targets entsprechend der vorliegenden Erfindung erzielt wurden. Nach dem Sputtertest wies das Target zahlreiche kleine Pickel auf. Außer in einem oberflächlichen Reaktionssaum zeigte die metallographische Untersuchung des Targets keinen nennenswerten Gehalt an metallischen Phasen und keine Anzeichen von Rekristallisation.

## Patentansprüche

1. Sputtertarget für die Kathodenzerstäubung zur Herstellung transparenter elektrisch leitfähiger Schichten, hergestellt aus teilweise reduzierten Indiumoxid-Zinnoxid-Pulvergemischen oder teilweise reduzierten kogefällten Indiumoxid-Zinnoxid-Pulvern, **dadurch gekennzeichnet**, daß das Target aus einer oxidkeramischen Matrix besteht, in die metallische Phasenteile aus In und/oder Sn mit Größen unterhalb 50 µm in gleichmäßiger und fein verteilter Weise eingelagert sind und das eine Dichte von mehr als 96 % der theoretischen Dichte des volloxydischen Indiumoxids/Zinnoxids aufweist.

2. Sputtertarget nach Anspruch 1, **dadurch gekennzeichnet**, daß der wesentliche Anteil der Metallphasen kleiner als 10 µm ist.

3. Sputtertarget entsprechend der Ansprüche 1 und 2, **dadurch gekennzeichnet**, daß die Bruchzähigkeit des Targetmaterials größer als 1,5 MPa√m ist.

4. Verfahren zur Herstellung eines Sputtertargets entsprechend den Ansprüchen 1, 2 oder 3, **dadurch gekennzeichnet**, daß Indiumoxid-Zinnoxid-Pulvergemische oder kogefällte Indiumoxid-Zinnoxid-Pulver einer Glühbehandlung bei Temperaturen unterhalb 1000°C in einer reduzierten Gasatmosphäre unterworfen werden, so daß sich in gleichmäßiger Weise fein verteilte metallische Phasen mit Größen unterhalb 50 µm bilden und das so erhaltene Pulver über heißisostatische Pressen bei Temperaturen oberhalb des Schmelzpunktes der metallischen Phasen kompaktiert wird.

5. Verfahren entsprechend Anspruch 4, **dadurch gekennzeichnet**, daß die überwiegende Zahl der sich bei der Reduktionsglühung bildenden metallischen Phasen Größen kleiner 10 µm aufweisen.

## Claims

1. Sputtering target for cathode sputtering in the manufacture of transparent electroconductive coatings, which is manufactured from partly reduced indium oxide/tin oxide powder mixtures or partly reduced co-precipitated indium oxide/tin oxide powders,
characterised in that the target consists of an oxide ceramic matrix,into which the metal phase particles composed of In and/or Sn and having a size of less than 50 µm are embedded in an even and finely distributed manner, and which has a density of more than 96% of the theoretical density of the fully oxidic indium oxide/tin oxide.

2. Sputtering target according to claim 1, characterised in that the majority of the metal phases have a size of less than 10 µm.

3. Sputtering target according to claims 1 and 2, characterised in that the fracture toughness of the target material is higher than 1.5 MPa√m.

4. Process for manufacturing a sputter target according to claims 1, 2 or 3, characterised in that indium oxide/tin oxide powder mixtures are subjected to an annealing treatement at temperatures of below 1000°C in a reduced gas atmosphere, so that metal phases with sizes of less than 50 µm are formed in a finely distributed,
homogeneous manner, and the powder thus formed is compacted by way of hot isostatic presses at temperatures above the melting point of the metal phases.

5. Process according to claim 4, characterised in that the majority of the metal phases formed during reducing annealing have sizes of less than 10 µm.

## Revendications

1. Cible de pulvérisation pour la pulvérisation cathodique en vue de la formation de couches transparentes conductrices de l'électricité, ladite cible étant fabriquée à partir de mélanges de poudres d'oxyde d'indium et d'oxyde d'étain partiellement réduites ou de poudres d'oxyde d'indium-oxyde d'étain coprécipités partiellement réduites, caractérisée en ce qu'elle consiste en une gangue de céramique d'oxydes dans laquelle les fractions de phases métalliques consistant en In et/ou Sn sont occluses à des dimensions inférieures à 50 µm, en répartition uniforme et à l'état de fine division, et en ce qu'elle a une densité supérieure à 96 % de la densité théorique de l'oxyde d'indium/oxyde d'étain entièrement à l'état d'oxydes.

2. Cible de pulvérisation selon revendication 1 caractérisée en ce que la plus grande partie des phases métalliques ont des dimensions inférieures à 10 µm.

3. Cible de pulvérisation selon les revendications 1 et 2 caractérisée en ce que la résistance à la rupture de la matière de la cible est supérieure à 1,5 MPa√m.

4. Procédé de préparation d'une cible de pulvérisation selon revendication 1, 2 ou 3, caractérisé en ce que l'on soumet des mélanges de poudres d'oxyde d'indium et d'oxyde d'étain ou des poudres d'oxyde d'indium-oxyde d'étain coprécipités à un traitement de calcination à des températures inférieures à 1000°C en atmosphère gazeuse réductrice de sorte qu'il se forme, en répartition uniforme et à l'état de fine division, des phases métalliques à des dimensions inférieures à 50 µm, et on soumet la poudre obtenue à moulage par compression isostatique à chaud à des températures supérieures au point de fusion des phases métalliques.

5. Procédé selon revendication 4, caractérisé en ce que le plus grand nombre des phases métalliques qui se forment à la calcination réductrice ont des dimensions supérieures à 10 µm.
